# EUROPEAN PATENT APPLICATION

(11) **EP 4 576 966 A1**
(43) Date of publication of application: **25.06.2025**
(21) Application number: 23891439.4
(22) Date of filing: 08.11.2023
(51) Int. Cl.: H05K 7/20, H01G 17/00, H01L 23/34, H01L 25/07, H01L 25/18, H02M 7/48

(54) **POWER SUPPLY MODULE**

(30) Priority: 16.11.2022 JP 2022183679
(71) Applicant: AISIN CORPORATION, Kariya-shi, Aichi 448-8650 (JP)
(72) Inventor: NITTA Masaru, Kariya-shi, Aichi 448-8650 (JP); KOASHI Hidefumi, Kariya-shi, Aichi 448-8650 (JP)
(74) Representative: Kramer Barske Schmidtchen Patentanwälte PartG mbB
(86) International application number: PCT/JP2023/040204
(87) International publication number: WO 2024/106287

(57) **Abstract**

A power supply module includes: a plurality of drive boards configured to separately drive electronic circuits composed of a plurality of electronic components that generates different amounts of heat; a heat shield electronic component composed of one of the plurality of electronic components, the heat shield electronic component separating the plurality of drive boards from each other; and a heat transfer reducing member configured to reduce heat transfer from one of the drive boards to the other drive board via the heat shield electronic component, the heat transfer reducing member overlapping at least part of the drive board as viewed in plan.

## Description

### TECHNICAL FIELD

The present disclosure relates to power supply modules.

### BACKGROUND ART

A power supply module equipped with electronic circuits such as an inverter and a converter is conventionally known in the art (see, for example, Patent Document 1). For example, this power supply module converts power supplied from a commercial power supply and charges a battery with the converted power, or converts power supplied from a battery mounted on a vehicle such as an automobile and supplies the converted power to an electronic device such as a motor.

In the power supply module described in Patent Document 1, a case is divided into upper and lower spaces, and a converter circuit is disposed in the upper space and an inverter circuit is disposed in the lower space. A cooling channel through which a coolant flows is provided at the bottom of the lower space, and heat is transferred to the metal case to cool the converter circuit and the inverter circuit.

### Related Art Documents

### Patent Documents

Patent Document 1: Japanese Unexamined Patent Application Publication No. 11-121690 (JP 11-121690 A)

### SUMMARY OF THE INVENTION

### Problem to be Solved by the Invention

A power supply module uses various electronic components that generate different amounts of heat, such as a switching element, a reactor, a capacitor, and a transformer. In the power supply module described in Patent Document 1 described in Patent Document 1, the converter circuit and the inverter circuit are separately disposed in the upper space and the lower space, respectively. Therefore, for example, heat from a switching element of the converter circuit, namely an element that generates a relatively large amount of heat, raises the ambient temperature via air. In this case, the heat stagnates, which tends to reduce cooling efficiency.

Accordingly, there is a demand for a compact power supply module that can improve cooling efficiency.

### Means for Solving the Problem

A characteristic configuration of a power supply module according to the present disclosure is that the power supply module includes: a plurality of drive boards configured to separately drive electronic circuits composed of a plurality of electronic components that generates different amounts of heat; a heat shield electronic component composed of one of the plurality of electronic components, the heat shield electronic component separating the plurality of drive boards from each other; and a heat transfer reducing member configured to reduce heat transfer from one of the drive boards to the other drive board via the heat shield electronic component, the heat transfer reducing member overlapping at least part of the drive board as viewed in plan.

Of the plurality of driver boards configured to separately drive the plurality of electronic circuits, heat from the electronic circuit mounted on one of the drive boards may be transferred via air to the electronic circuit mounted on the other drive board, which may reduce cooling efficiency.

Therefore, this configuration includes: the heat shield electronic component that separates the plurality of drive boards from each other; and the heat transfer reducing member that is configured to reduce heat transfer from one of the drive boards to the other drive board via the heat shield electronic component and that overlaps at least part of the drive board as viewed in plan. This allows the electronic circuits that are separately controlled by the drive boards to be independently cooled by the heat shield electronic component and the heat transfer reducing member. Moreover, since the heat shield electronic component is composed of one of the plurality of electronic components, there is no need to provide a separate heat shield member. The power supply module can thus be made compact.

The compact power supply module that can improve cooling efficiency is thus provided.

### BRIEF DESCRIPTION OF THE DRAWINGS

[FIG. 1] FIG. 1 is a circuit configuration diagram of a cooling system including a power supply module according to a first embodiment.
[FIG. 2] FIG. 2 is an exploded perspective view of the power supply module.
[FIG. 3] FIG. 3 is a longitudinal section of the power supply module.
[FIG. 4] FIG. 4 is an enlarged view of a portion B in FIG. 3.
[FIG. 5] FIG. 5 is a sectional view taken along line V-V and viewed in the direction of the arrows in FIG. 2.
[FIG. 6] FIG. 6 is a partial longitudinal section of a power supply module according to a second embodiment.
[FIG. 7] FIG. 7 is a partial longitudinal section of a power supply module according to a third embodiment.
[FIG. 8] FIG. 8 is a partial enlarged plan view of the power supply module.
[FIG. 9] FIG. 9 is a sectional view taken along line IX-IX and viewed in the direction of the arrows in FIG. 8.

### MODES FOR CARRYING OUT THE INVENTION

Hereinafter, embodiments of a power supply module according to the present disclosure will be described in detail with reference to the drawings. The embodiments described below are merely examples illustrating the present disclosure, and the present disclosure is not limited to only these embodiments. Therefore, the present disclosure can be carried out in various forms without departing from the spirit and scope of the present disclosure.

### [Configuration of Cooling Circuit]

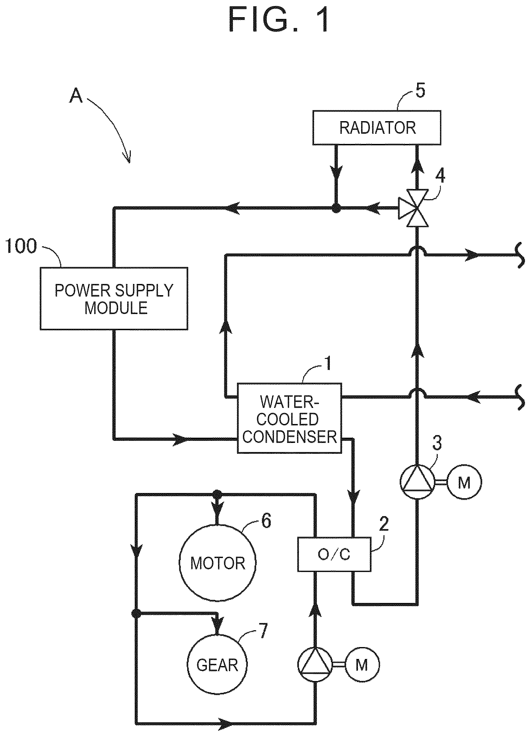

As shown in FIG. 1, a cooling circuit A including a power supply module 100 according to an embodiment cools the power supply module 100 with a cooling fluid. The cooling fluid refers to a coolant such as long-life coolant (LLC), insulating oil such as paraffin-based oil, or a cooling medium such as a hydrofluorocarbon (HFC) or a hydrofluoroolefin (HFO). In the present embodiment, it is preferable to use a liquid with high electrical insulation properties, such as a coolant like long-life coolant (LLC) or a fluorine-based inert liquid. A cooling liquid composed of a coolant or insulating oil may be used. The cooling circuit A is mounted on a vehicle that charges a battery (not shown) with external power.

The cooling circuit A is composed of the power supply module 100, a water-cooled condenser 1, an oil cooler 2, a water pump 3, a three-way valve 4, and a radiator 5. The cooling fluid heated by cooling the power supply module 100 flows out of the power supply module 100, is then heated by heat exchange with a cooling medium in the water-cooled condenser 1, and thereafter is further heated by heat exchange with lubricating oil in the oil cooler 2. Subsequently, the cooling fluid is pumped by the water pump 3 and switched by the three-way valve 4 between being sent to the radiator 5 and not being sent to the radiator 5. When the cooling fluid is sent to the radiator 5, the cooling fluid is cooled by the radiator 5 and flows back into the power supply module 100. When the cooling fluid is not sent to the radiator 5, the heated cooling fluid flows back into the power supply module 100 without being cooled.

### [First Embodiment]

### [Configuration of Power Supply Module]

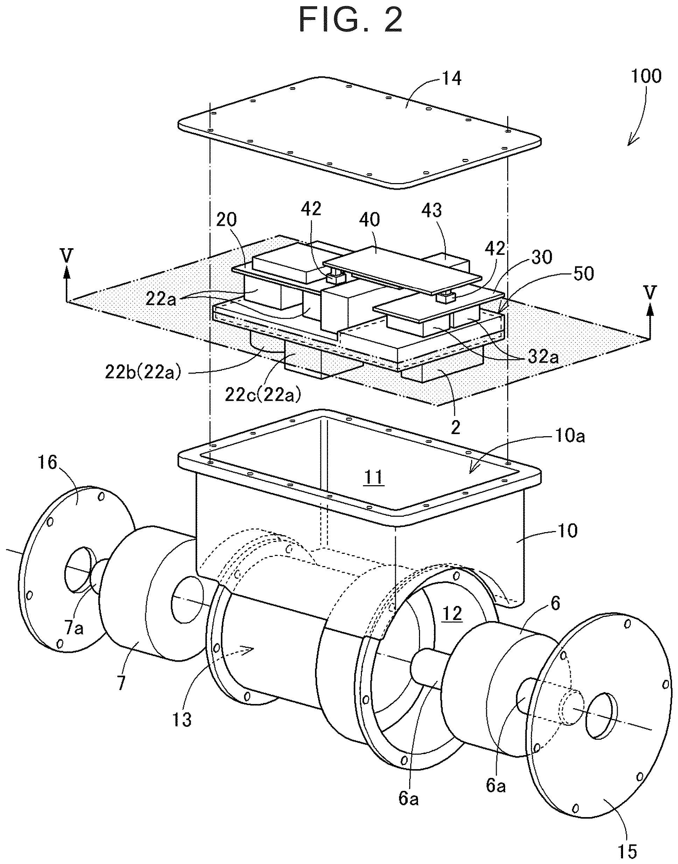

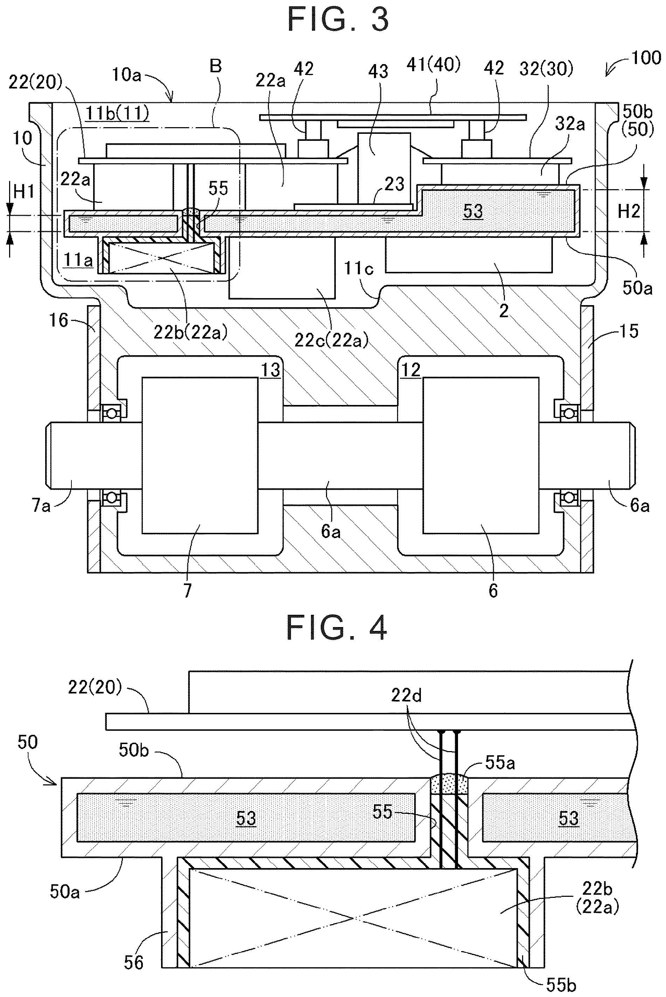

As shown in FIG. 2, the power supply module 100 according to the first embodiment is formed by housing, in a housing 10, at least an OBC (On Board Charger) board 20 (example of the drive board), a motor drive board 30 (example of the drive board), and a control board 40 (example of the heat transfer reducing member) that controls the OBC board 20 and the motor drive board 30. The power supply module 100 has a first space 11. The OBC board 20, the motor drive board 30, and the control board 40 are separate boards and are housed in the first space 11 in attitudes parallel to each other. FIG. 3 shows a section taken along a direction perpendicular to a board surface of the OBC board 20 (motor drive board 30, control board 40). Hereinafter, the direction perpendicular to the board surface of the OBC board 20 will be referred to as "vertical direction." A direction in which the control board 40 is viewed from the OBC board 20 and the motor drive board 30 along the vertical direction in FIG. 3 will be referred to as "upward direction," "upper side," etc., and the direction in which the OBC board 20 and the motor drive board 30 are viewed from the control board 40 along the vertical direction in FIG. 3 will be referred to as "downward direction," "lower side," etc.

The housing 10 has a second space 12 and a third space 13 that are separated from the first space 11. The second space 12 and the third space 13 are located below the first space 11. A motor 6 that is driven by the motor drive board 30 is housed in the second space 12, and a gear mechanism 7 that reduces the rotational speed of the motor 6 and outputs the resultant rotation is housed in the third space 13. The housing 10 has an opening 10a on the upper side of the first space 11, and the OBC board 20, the motor drive board 30, the control board 40, and a cooling plate 50 are placed into the first space 11 from the opening 10a. The opening 10a is closed by a lid 14 (see FIG. 2), so that the first space 11 is a closed space. The motor 6 is placed into the second space 12 from the side. The second space 12 is a closed space closed by a motor cover 15 fastened with bolts, not shown. Motor shafts 6a extend from both sides of the motor 6 along its rotation axis. One of the motor shafts 6a extends through the motor cover 15 and is exposed to the outside of the housing 10. The other motor shaft 6a extends into the third space 13. The gear mechanism 7 is placed into the third space 13 from the side. The third space 13 is a closed space closed by a gear cover 16 fastened with bolts (not shown). The other motor shaft 6a extending from the second space 12 is connected to the gear mechanism 7, so that rotation of the motor 6 is input to the gear mechanism 7 via the motor shaft 6a. The gear mechanism 7 reduces the rotational speed of the motor 6 and outputs the resultant rotation from a gear shaft 7a. The gear shaft 7a extends through the gear cover 16 and is exposed to the outside of the housing 10.

A power converter 22 (example of the electronic circuit) is mounted on the OBC board 20. The power converter 22 includes at least an AC-DC converter that converts an externally input alternating current to a direct current and a DC-DC converter that converts a direct current voltage to a direct current voltage suitable for charging the battery, not shown. Since the configurations of AC-DC converters and DC-DC converters are known in the art, detailed description thereof will be omitted.

A power converter 32 (example of the electronic circuit) is mounted on the motor drive board 30. The power converter 32 includes at least an inverter that controls a drive current for driving the motor 6. Since the configuration of inverters is known in the art, detailed description thereof will be omitted. A control circuit 41 that controls the power converter 22 and the power converter 32 is mounted on the control board 40.

The AC-DC converter and DC-DC converter of the power converter 22 include a heat-generating component 22a (example of the electronic component), and the inverter of the power converter 32 includes a heat-generating component 32a (example of the electronic component). Examples of the heat-generating component 22a included in the power converter 22 includes a reactor 22b (example of the electronic component), a transformer 22c (example of the electronic component), a diode (example of the electronic component), and a switching element (example of the electronic component). Examples of the heat-generating component 32a included in the power converter 32 include a diode (example of the electronic component) and a switching element (example of the electronic component). These electronic components have different heights.

In the present embodiment, the OBC board 20 and the motor drive board 30 are located at the same height in the vertical direction. The control board 40 is disposed so as to overlap at least a partial region (region near a film capacitor 43 described later) of each of the OBC board 20 and the motor drive board 30 as viewed in the vertical direction (as viewed in plan). Board-to-board connectors 42 are used to connect the OBC board 20 and the control board 40 and to connect the motor drive board 30 and the control board 40. Hereinafter, the board-to-board connectors 42 will be simply referred to as the connectors 42. In the present embodiment, the OBC board 20 and the motor drive board 30 are located at the same height in the vertical direction. Therefore, two of the same type of connectors 42 can be used to connect the OBC board 20 and the control board 40 and to connect the motor drive board 30 and the control board 40. This configuration facilitates mounting of the control board 40 to the OBC board 20 and the motor drive board 30, and provides ease of assembly because there is no need to use different types of connectors.

### [Cooling Plate]

The cooling plate 50 that cools the heat-generating component 22a of the power converter 22 and the heat-generating component 32a of the power converter 32 is housed in the first space 11 of the housing 10. The cooling plate 50 is made of a metal with high thermal conductivity, such as aluminum, and is integrally formed by joining a lower plate 50a and an upper plate 50b, each having the shape of a plate, by a method such as welding. The cooling plate 50 has a space inside (between the lower plate 50a and the upper plate 50b), and the cooling fluid flows through the space. The heat-generating component 22a is mounted on the lower surface of the OBC board 20, and the heat-generating component 32a is mounted on the lower surface of the motor drive board 30. The heat-generating component 22a and the heat-generating component 32a are both disposed so as to contact the cooling plate 50. The temperatures of the heat-generating components 22a, 32a are lowered and the temperature of the cooling fluid is raised by heat exchange between each of the heat-generating components 22a, 32a and the cooling fluid. Both the heat-generating component 22a and the heat-generating component 32a may be disposed so as to be fixed to the cooling plate 50.

As described above, the OBC board 20 and the motor drive board 30 are located at the same height in the vertical direction. In order to implement this, the power supply module 100 of the present embodiment includes a height adjustment mechanism. Specifically, the channel height H1 in the vertical direction of a portion facing the OBC board 20 (portion that overlaps the OBC board 20 as viewed in the vertical direction) is made different from the channel height H2 in the vertical direction of a portion facing the motor drive board 30 (portion that overlaps the motor drive board 30 as viewed in the vertical direction). In the present embodiment, the channel height H2 is greater than the channel height H1. That is, the height adjustment mechanism of the present embodiment is to make the channel heights H1, H2 of the cooling plate 50 different depending on the board that the cooling plate 50 faces.

In the present embodiment, of the lower plate 50a and upper plate 50b of the cooling plate 50, the lower plate 50a is in the shape of a flat plate, but the upper plate 50b has different heights in its portion corresponding to the OBC board 20 and its portion corresponding to the motor drive board 30. Specifically, the portion of the upper plate 50b that corresponds to the motor drive board 30 has a greater height from the lower plate 50a than the portion of the upper plate 50b that corresponds to the OBC board 20. As described above, the heat-generating component 22a used in the power converter 22 of the OBC board 20 and the heat-generating component 32a used in the power converter 32 of the motor drive board 30 are both cooled by contact with the upper plate 50b of the cooling plate 50. That is, the heat-generating component 22a of the power converter 22 has a great mounting height, while the heat-generating component 32a of the power converter 32 on the motor drive board 30 has a small mounting height.

Therefore, in the upper plate 50b of the present embodiment, the channel height H2 is made greater than the channel height H1 by an amount corresponding to the difference between the mounting height of the heat-generating component 22a and the mounting height of the heat-generating component 32a. This allows the OBC board 20 and the motor drive board 30 to be aligned at the same height in the vertical direction with both the tall heat-generating component 22a and the short heat-generating component 32a in contact with the upper plate 50b.

The heat-generating component 32a of the power converter 32 on the motor drive board 30 typically generates a relatively larger amount of heat than the heat-generating component 22a of the power converter 22 on the OBC board 20 does. Therefore, by making the channel height H2 where the heat-generating component 32a contacts greater than the channel height H1 where the heat-generating component 22a contacts, the channel sectional area for the cooling fluid can be made larger in the portion that the heat-generating component 32a contacts than in the portion that the heat-generating component 22a contacts. This allows efficient cooling of the heat-generating component 32a.

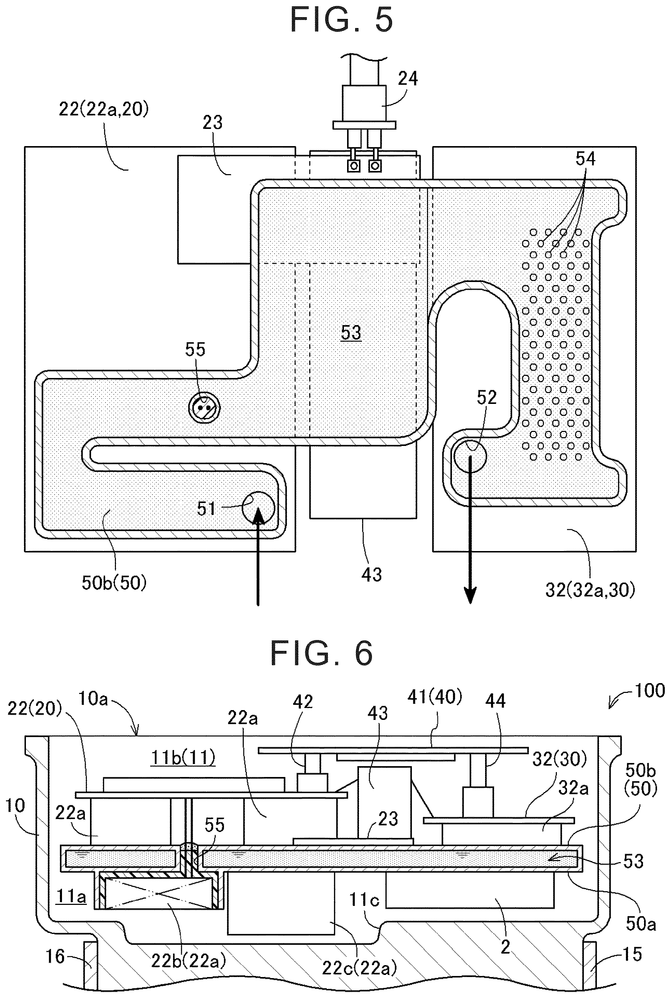

A channel 53 of the cooling plate 50 is disposed as shown in FIG. 5 as viewed in the vertical direction. In the present embodiment, when the cooling fluid flows in through a cooling fluid inlet 51 of the cooling plate 50, the cooling fluid first flows through a portion corresponding to the heat-generating component 22a of the power converter 22 on the OBC board 20 on the upstream side, and then flows through a portion corresponding to the heat-generating component 32a of the power converter 32 on the motor drive board 30 on the downstream side, before flowing out through an outlet 52. That is, the cooling fluid first cools the heat-generating component 22a that generates a relatively small amount of heat, and then cools the heat-generating component 32a that generates a relatively large amount of heat. If the channel is configured so that the cooling fluid first cools the heat-generating component 32a and then cools the heat-generating component 22a, the cooling fluid would be sufficiently heated by cooling the heat-generating component 32a and therefore would not be able to sufficiently cool the heat-generating component 22a. However, by configuring the channel 53 so that the heat-generating component 32a is cooled after the heat-generating component 22a is cooled, the cooling fluid can efficiently cool both of the heat-generating components 22a, 32a.

The channel 53 has a plurality of protrusions 54 on the downstream side of the channel 53 that faces the heat-generating component 32a. The protrusions 54 are formed on either or both of the upper plate 50b and the lower plate 50a so as to protrude from the outside toward the inside to hinder the flow of the cooling fluid. The protrusions 54 have the shape of a spherical cap, and are arranged in a staggered pattern with respect to the flow direction of the cooling fluid. For example, when the protrusions 54 are arranged on the lower plate 50a, the protrusions 54 lifts the coolant located near the lower plate 50a toward the upper plate 50b, generating a vortex. This causes the cooling fluid located near the upper plate 50b and the cooling fluid located near the lower plate 50a to mix together, so that the coolant temperature near the upper plate 50b can be lowered. The cooling fluid located near the upper plate 50b thus has a lowered temperature and can absorb more heat, and therefore can further lower the temperature of the heat-generating component 32a.

As shown in FIGS. 3 and 5, a metal base board 23 is disposed on the upper plate 50b. The film capacitor 43 described later and a connection terminal 24 to which a direct current voltage from the battery, not shown, is input are attached to the metal base board 23.

### [Film Capacitor]

As described above, the OBC board 20 and the motor drive board 30 are separate boards. In the present embodiment, as shown in FIG. 2, the film capacitor 43 (example of the electronic component, a heat shield electronic component) is disposed between the OBC board 20 and the motor drive board 30. The film capacitor 43 is used both for smoothing the inverter of the power converter 32 and for smoothing the secondary side of the DC-DC converter of the power converter 22. That is, the film capacitor 43 serves to perform two different kinds of smoothing.

The film capacitor 43 has a height from near the upper plate 50b of the cooling plate 50 to near the control board 40 in the vertical direction. That is, as shown in FIG. 3, the film capacitor 43 has a greater height in the vertical direction than electronic components mounted on the OBC board 20, including the heat-generating component 22a, and electronic components mounted on the motor drive board 30, including the heat-generating component 32a. The distance between the upper surface of the film capacitor 43 and the lower surface of the control board 40 is smaller than the distance between each of the upper surfaces of the OBC board 20 and motor drive board 30 and the lower surface of the control board 40. Therefore, the periphery of the motor drive board 30 is surrounded by the control board 40, the film capacitor 43, and a wall surface of the housing 10, and is separated from the periphery of the OBC board 20. This can reduce transfer of heat generated by the power converter 32 of the motor drive board 30 to the OBC board 20.

### [Arrangement of Tall Electronic Components]

As shown in FIG. 3, the first space 11 is divided by the cooling plate 50 into a first region 11a located below the cooling plate 50 and a second region 11b located above the cooling plate 50. In the present embodiment, the capacity of the first region 11a is smaller than that of the second region 11b. In the first space 11, the plurality of electronic components of the power converter 22 (including the heat-generating component 22a) and the plurality of electronic components of the power converter 32 (including the heat-generating component 32a) are all disposed in the first region 11a and the second region 11b. The OBC board 20, the motor drive board 30, and the control board 40 are disposed in the second region 11b.

In the present embodiment, the reactor 22b and transformer 22c of the power converter 22 and the oil cooler 2 are disposed in the first region 11a. The diodes, switching elements, etc. of the power converter 22 and power converter 32 are disposed in the second region 11b. The reactor 22b, transformer 22c, and oil cooler 2 disposed in the first region 11a are in contact with the lower plate 50a of the cooling plate 50, and the diodes and switching elements disposed in the second region 11b are in contact with the upper plate 50b. Of the electronic components, the electronic components with relatively large heights are housed and arranged in the first region 11a, and the electronic components with relatively small heights are housed and arranged in the second region 11b.

The first region 11a is adjacent to the second space 12 in which the motor 6 is disposed and the third space 13 in which the gear mechanism 7 is disposed, with a wall of the housing 10 between the first region 11a and the second space 12 and third space 13. That is, the first region 11a faces the motor 6 and the gear mechanism 7 with the wall of the housing 10 between the first region 11a and the motor 6 and gear mechanism 7. The first region 11a has, in its portion facing the gear mechanism 7, a recess 11c recessed toward the third space 13. The portion of the first region 11a where the recess 11c is formed therefore has a greater height (depth) downward (toward the gear mechanism 7) from an imaginary reference plane (lower plate 50a of the cooling plate 50).

Of the reactor 22b and transformer 22c disposed in the first region 11a, the transformer 22c has a relatively greater height. In the present embodiment, as shown in FIG. 3, the reactor 22b is therefore disposed in a portion that does not face the recess 11c, and the transformer 22c is disposed in a portion that faces the recess 11c. The transformer 22c is disposed in such a manner that part of the transformer 22c is located in the recess 11c. Arranging the reactor 22b and the transformer 22c in this manner makes it possible to effectively use the recess 11c in the first region 11a, so that the size of the power supply module 100 can be reduced.

### [Providing Insulation by Potting]

In the present embodiment, the reactor 22b and the transformer 22c are disposed in the first region 11a of the first space 11, the OBC board 20 is disposed in the second region 11b, and the first region 11a and the second region 11b are separated by the cooling plate 50. A pair of lead wires 22d located at both ends of a coil winding of the reactor 22b needs to be electrically connected to the OBC board 20. Therefore, in the present embodiment, a configuration in which a through hole 55 is formed in the cooling plate 50 and the lead wires 22d of the reactor 22b are passed through the through hole 55 and electrically connected to the OBC board 20 will be described with reference to FIG. 4. Although not described in the present embodiment, the same configuration is applicable to lead wires of a coil winding of the transformer 22c and other electronic components disposed in the first region 11a.

First, a method for forming the through hole 55 will be described. The upper plate 50b and lower plate 50a of the cooling plate 50 are joined together by friction stir welding from the upper plate 50b to the lower plate 50a while forming a hole. That is, as shown in FIG. 4, the through hole 55 is formed in the channel 53, but the periphery of the through hole 55 is surrounded by the upper plate 50b and lower plate 50a joined together, so that the cooling fluid flowing from the through hole 55 through the channel 53 will not leak into the through hole 55.

Next, the reactor 22b is disposed in a reactor housing portion 56 formed in the lower plate 50a, and the lead wires 22d are passed through the through hole 55. The lead wires 22d are thus exposed in the second region 11b. Ends of the lead wires 22d are electrically connected to the OBC board 20.

Next, a sealant 55a is dropped into an end on the second region 11b side of the through hole 55 to seal the end. The lead wires 22d are thus fixed. The reactor housing portion 56 is thus filled with a resin potting material 55b. The potting material 55b covers the entire periphery (all side surfaces) and bottom surface of the reactor 22b and also flows into the through hole 55. When the potting material 55b is cured, the potting material 55b filled between the cooling plate 50 (the lower plate 50a and the upper plate 50b) and the reactor 22b and the lead wires 22d provides insulation of the reactor 22b and the lead wires 22d.

As described above, this simple configuration in which the through hole 55 is formed in the cooling plate 50, the lead wires 22d are passed through the through hole 55, and the potting material 55b is placed in the cooling plate 50 provides insulation of the reactor 22b and the lead wires 22d from the cooling plate 50, and also reduces the risk of breaking of the lead wires 22d because there is no need to run the lead wires 22d a long distance from the outside of the cooling plate 50.

### [Effects of First Embodiment]

In the present embodiment, the power supply module 100 includes: the OBC board 20 and the motor drive board 30 that separately drive the power converters 22, 32 such as, for example, converters and inverters, respectively; and the control board 40 that controls these boards. In other words, since the common control board 40 that is composed of a CPU etc. and that operates the OBC board 20 and the motor drive board 30 is used, it is only necessary to connect the common control board 40 to the OBC board 20 and the motor drive board 30 using the connectors 42. This provides ease of assembly.

The channel 53 that causes the cooling fluid to flow from the heat-generating component 22a that generates a relatively small amount of heat to the heat-generating component 32a that generates a relatively large amount of heat is formed in the cooling plate 50 of the present embodiment. This can eliminate the need for other electronic components to be heated by the cooling fluid heated by the heat-generating component 32a that generates a relatively large amount of heat. Moreover, since the heat-generating component 22a that generates a relatively small amount of heat is cooled first, the heat-generating component 32a that generates a relatively large amount of heat can also be cooled by the cooling liquid.

The present embodiment includes the film capacitor 43 that separates the OBC board 20 and the motor drive board 30 from each other, and the control board 40 that reduces heat transfer from the motor drive board 30 to the OBC board 20 via the film capacitor 43. The film capacitor 43 and the control board 40 thus allow the power converter 22 that is controlled by the OBC board 20 and the power converter 32 that is controlled by the motor drive board 30 to be independently cooled. Moreover, since heat is blocked by the film capacitor 43, there is no need to provide a separate member for blocking heat. The power supply module 100 can thus be made compact.

The present embodiment includes the housing 10 that houses the OBC board 20, the motor drive board 30, and the control board 40, and the first space 11 of the housing 10 is divided into the first region 11a and the second region 11b with respect to the cooling plate 50. Tall electronic components such as the reactor 22b and the transformer 22c are housed in a region with a relatively large capacity in the first region 11a that is one of these two regions. The power supply module 100 can thus be made compact by disposing the reactor 22b and the transformer 22c in the first region 11a with a large capacity in the first space 11 and disposing other short electronic components in the second region 11b. Of the reactor 22b and the transformer 22c, the relatively tall transformer 22c is disposed in a relatively tall region in the first region 11a. This can improve space utilization efficiency.

In the present embodiment, the lead wires 22d extending from the reactor 22b disposed on the opposite side of the cooling plate 50 from the OBC board 20 are fixed in the through hole 55 in the cooling plate 50 by the potting material 55b. Therefore, there is no need to detour the lead wires 22d, so that the lead wires 22d can extend through the channel 53 by the shortest route. Moreover, insulation is provided by merely fixing in the through hole 55 in the cooling plate 50 by the potting material 55b. This facilitates processing.

### [Second Embodiment]

Next, the configuration of the power supply module 100 according to a second embodiment will be described with reference to FIG. 6. In the present embodiment, unlike the first embodiment, the cooling plate 50 has a constant channel height. Therefore, the positions in the vertical direction of (vertical distances to) the OBC board 20 and the motor drive board 30 are different as viewed from the control board 40. Specifically, the vertical distance between the control board 40 and the motor drive board 30 is greater than in the first embodiment. The configuration of the present embodiment is otherwise the same as the first embodiment. Therefore, in the description of the present embodiment, the portions with the same configurations as the first embodiment are denoted with the same signs, and detailed description of the same configurations will be omitted.

The present embodiment includes a height adjustment mechanism in order to control the power converter 22 on the OBC board 20 and the power converter 32 on the motor drive board 30 by the control circuit 41 of the common control board 40. The height adjustment mechanism of the present embodiment is to make the height of a connector connecting the OBC board 20 and the control board 40 different from the height of a connector connecting the motor drive board 30 and the control board 40. Specifically, the motor drive board 30 and the control board 40 are connected using a tall board-to-board connector 44 (hereinafter simply referred to as the tall connector 44) that is taller than the connector 42. This makes it possible to control the power converter 22 on the OBC board 20 and the power converter 32 on the motor drive board 30 using the common control board 40 even when the vertical positions of the OBC board 20 and the motor drive board 30 are different as viewed from the control board 40.

The use of the tall connector 44 having a different height from the connector 42 as in the present embodiment allows tolerance to be absorbed by the connectors by first connecting one of the OBC board 20 and the motor drive board 30 to the control board 40 and then connecting the other board to the control board 40 when mounting the OBC board 20 and the motor drive board 30 to the common control board 40.

### [Third Embodiment]

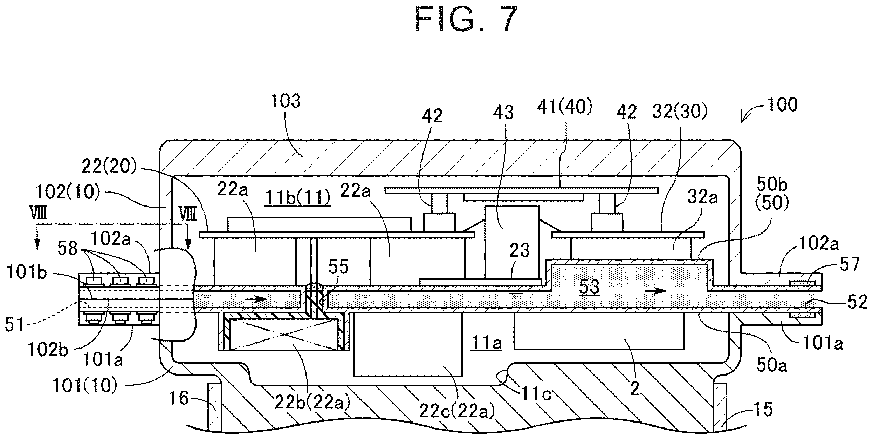

Next, the configuration of the power supply module 100 according to a third embodiment will be described with reference to FIGS. 7 to 9. The present embodiment is different from the first and second embodiments in the configuration of the cooling plate 50. The configuration of the present embodiment is otherwise the same as the first and second embodiments. Therefore, in the description of the present embodiment, the portions with the same configurations as the first and second embodiments are denoted with the same signs, and detailed description of the same configurations will be omitted.

In the present embodiment, the housing 10 is formed by joining a first housing 101 and a second housing 102. The cooling plate 50 is disposed at the boundary between the first housing 101 and the second housing 102. Therefore, the first region 11a of the first space 11 is formed by the first housing 101 and the cooling plate 50, and the second region 11b of the first space 11 is formed by the second housing 102 and the cooling plate 50. Therefore, the reactor 22b and the transformer 22c are housed in the first housing 101.

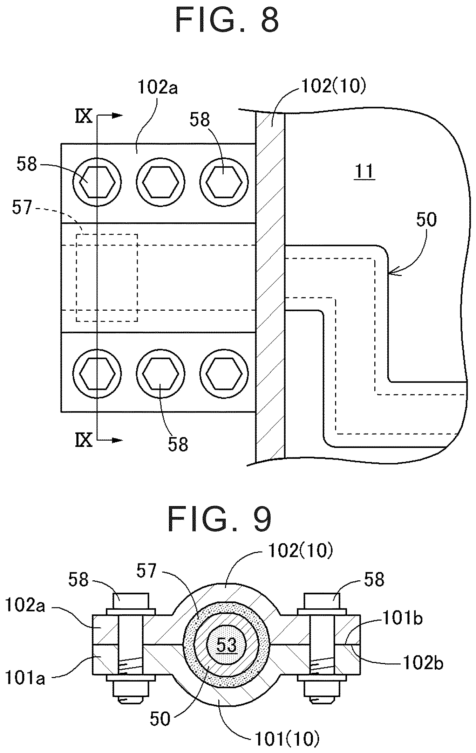

The inlet 51 and outlet 52 of the cooling plate 50 are formed in a cylindrical shape as shown in FIG. 9. As shown in FIG. 7, the inlet 51 and the outlet 52 are formed at both ends in a horizontal direction (direction parallel to the plate surface of the OBC board 20) of the cooling plate 50. The inlet 51 and the outlet 52 are clamped between a first contact surface 101b of a first protruding portion 101a of the first housing 101 and a second contact surface 102b of a second protruding portion 102a of the second housing 102, and an end of the inlet 51 and an end of the outlet 52 are exposed and visible from outside the housing 10. The inlet 51 and the outlet 52 are connected to the cooling plate 50 by screw connection.

The first protruding portion 101a of the first housing 101 and the second protruding portion 102a of the second housing 102 are fastened by bolts 58 with the first contact surface 101b and the second contact surface 102b in contact with each other and clamping the inlet 51 and outlet 52 of the cooling plate 50, as shown in FIGS. 8 and 9. Annular gaskets 57 are disposed between the inlet 51 and the first protruding portion 101a and second protruding portion 102a and between the outlet 52 and the first protruding portion 101a and second protruding portion 102a. Moreover, as shown in FIG. 7, the second housing 102 serves as a cooling manifold 103 having a channel (not shown) inside that forms part of the channel 53 of the cooling plate 50.

In the cooling plate 50 of the present embodiment, the inlet 51 and outlet 52 for the cooling fluid are each clamped between the first contact surface 101b of the first protruding portion 101a of the first housing 101 and the second contact surface 102b of the second protruding portion 102a of the second housing 102. Therefore, the channel 53 that is formed inside the cooling plate 50 can be designed independently for the cooling plate 50 alone, allowing high design flexibility of the channel shape. Moreover, since both ends of the cooling plate 50 where the inlet 51 and outlet 52 for the cooling fluid are formed are clamped between the first contact surface 101b of the first housing 101 and the second contact surface 102b of the second housing 102, the first housing 101, the cooling plate 50, and the second housing 102 need only be assembled in this order, which provides ease of assembly.

### [Other Embodiments]

(1) In the first embodiment, the film capacitor 43 is configured to be used both for smoothing the inverter of the power converter 32 and for smoothing the secondary side of the DC-DC converter of power converter 22. However, separate film capacitors, namely a film capacitor for smoothing the inverter of the power converter 32 and a film capacitor for smoothing the secondary side of the DC-DC converter of the power converter 22, may be provided, and at least one of them may be used as a heat shield electronic component.
(2) Although the control board 40 is used as a heat transfer reducing member, the present disclosure is not limited to this. A dedicated member may be used as a heat transfer reducing member. When the control board 40 is used as a heat transfer reducing member, it is preferable to mount heat-sensitive components such as the CPU on the upper side of the control board 40 (side that does not face the motor drive board 30). This configuration can reduce the influence of heat generation of the heat-generating component 32a on the motor drive board 30 on the components such as the CPU.
(3) In the first embodiment, the heat-generating components 22a, 32a disposed in the second region 11b of the first space 11 both have a smaller height than the film capacitor 43. However, the present disclosure is not limited to this. The film capacitor 43 can block heat of the heat-generating component 32a on the motor drive board 30 as long as the film capacitor 43 has a greater height than the heat-generating component 32a. Therefore, the heat-generating component 22a may have a greater height than the film capacitor 43.

The following configurations are possible for the embodiments described above.

<1> One embodiment of a power supply module (100) includes: a plurality of drive boards (20, 30) configured to separately drive electronic circuits (22, 32) composed of a plurality of electronic components (22a, 32a, 43) that generates different amounts of heat; a heat shield electronic component (43) composed of one of the plurality of electronic components (22a, 32a, 43), the heat shield electronic component (43) separating the plurality of drive boards (20, 30) from each other; and a heat transfer reducing member (40) configured to reduce heat transfer from one of the drive boards (20, 30) to the other drive board (30, 20) via the heat shield electronic component (43), the heat transfer reducing member (40) overlapping at least part of the drive board (20, 30) as viewed in plan.

Of the plurality of driver boards (20, 30) configured to separately drive the plurality of electronic circuits (22, 32), heat from the electronic circuit (22, 32) mounted on one of the drive boards (20, 30) may be transferred via air to the electronic circuit (32, 22) mounted on the other drive board (30, 20), which may reduce cooling efficiency.

Therefore, the present embodiment includes: the heat shield electronic component (43) that separates the plurality of drive boards (20, 30) from each other; and the heat transfer reducing member (40) that is configured to reduce heat transfer from one of the drive boards (20, 30) to the other drive board (30, 20) via the heat shield electronic component (43) and that overlaps at least part of the drive board (20, 30) as viewed in plan. This allows the electronic circuits (22, 32) that are separately controlled by the drive boards (20, 30) to be independently cooled by the heat shield electronic component (43) and the heat transfer reducing member (40). Moreover, since the heat shield electronic component (43) is composed of one of the plurality of electronic components (22a, 32a, 43), there is no need to provide a separate heat shield member. The power supply module (100) can thus be made compact.

The compact power supply module (100) that can improve cooling efficiency is thus provided.

<2> **In** the power supply module (100) according to <1>, it is preferable that the heat shield electronic component be a film capacitor (43).

**In** the case where a general-purpose capacitor that is used in the electronic circuits (22, 32) is used as the film capacitor (43) serving as the heat shield electronic component, convenience is improved.

<3> **In** the power supply module (100) according to <1> or <2>, it is preferable that the heat transfer reducing member be a control board (40) configured to control the drive board (20, 30).

**In** the case where the control board (40) is used as the heat transfer reducing member, the board configured to control the drive board (20, 30) can also serve as the heat transfer reducing member, which improves convenience.

<4> **In** the power supply module (100) according to <3>, it is preferable that the control board (40) is a common board configured to control the plurality of drive boards (20, 30).

**In** the case where the control board (40) is a common board configured to control the plurality of drive boards (20, 30), space utilization efficiency can be improved compared to the case where separate control boards (40) are provided for the drive boards.

<5> **In** the power supply module (100) according to <3> or <4>, it is preferable that the power supply module (100) further include a housing (10) that houses the drive board (20, 30) and that the control board (40) be housed in the housing (10).

**In** the case where the control board (40) is housed in the housing (10), it is possible to reduce transfer of heat generated by any one of the plurality of drive boards (20, 30) to the remainder of the drive boards (30, 20) inside the housing (10). It is also possible to make the power supply module (100) compact.

<6> **In** the power supply module (100) according to any one of <1> to <5>, it is preferable that the heat shield electronic component (43) be taller than the electronic components (22a, 32a) disposed near both sides of the heat shield electronic component (43).

**In** the case where the heat shield electronic component (43) is taller than the electronic components (22a, 32a) disposed near its both sides, heat transfer between the electronic components (22a, 32a) disposed near both sides of the heat shield electronic component (43) can be effectively reduced.

<7> In the power supply module (100) according to any one of <1> to <5>, it is preferable that a distance between the heat shield electronic component (43) and the heat transfer reducing member (40) be smaller than a distance between each of the plurality of drive boards (20, 30) and the heat transfer reducing member (40).

In the case where the distance between the heat shield electronic component (43) and the heat transfer reducing member (40) is shorter than the distance between each of the plurality of drive boards (20, 30) and the heat transfer reducing member (40), it is possible to reduce transfer of heat generated in any one of the plurality of drive boards (20, 30) to the remainder of the drive boards (30, 20).

### INDUSTRIAL APPLICABILITY

The present disclosure is applicable to power supply modules.

### Description of the Reference Numerals

10: housing, 20: OBC board (drive board), 22: power converter (electronic circuit), 22a: heat-generating component (electronic component), 30: motor drive board (drive board), 32: power converter (electronic circuit), 32a: heat-generating component (electronic component), 40: control board (heat transfer reducing member), 43: film capacitor (electronic component, heat shield electronic component), 100: power supply module

## Claims

1. A power supply module comprising:
a plurality of drive boards configured to separately drive electronic circuits composed of a plurality of electronic components that generates different amounts of heat;
a heat shield electronic component composed of one of the plurality of electronic components, the heat shield electronic component separating the plurality of drive boards from each other; and
a heat transfer reducing member configured to reduce heat transfer from one of the drive boards to the other drive board via the heat shield electronic component, the heat transfer reducing member overlapping at least part of the drive board as viewed in plan.

2. The power supply module according to claim 1, wherein the heat shield electronic component is a film capacitor.

3. The power supply module according to claim 1, wherein the heat transfer reducing member is a control board configured to control the drive board.

4. The power supply module according to claim 3, wherein the control board is a common board configured to control the plurality of drive boards.

5. The power supply module according to claim 3, further comprising a housing that houses the drive board, wherein the control board is housed in the housing.

6. The power supply module according to any one of claims 1 to 5, wherein the heat shield electronic component is taller than the electronic components disposed near both sides of the heat shield electronic component.

7. The power supply module according to any one of claims 1 to 5, wherein a distance between the heat shield electronic component and the heat transfer reducing member is smaller than a distance between each of the plurality of drive boards and the heat transfer reducing member.
